(19) Europäisches Patentamt
European Patent Office
Office européen des brevets

(11) **EP 4 421 510 A1**

(12) **EUROPEAN PATENT APPLICATION**

(43) Date of publication:
**28.08.2024   Bulletin 2024/35**

(21) Application number: **24154307.3**

(22) Date of filing: **29.01.2024**

(51) International Patent Classification (IPC):
**G01R 33/05** (2006.01)

(52) Cooperative Patent Classification (CPC):
**G01R 33/05; G01R 33/0094;** G01R 33/0011;
G01R 33/0047; G01R 33/063

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.02.2023   JP 2023025587**

(71) Applicants:
• **Shimadzu Corporation
Nakagyo-ku,
Kyoto-shi,
Kyoto 604-8511 (JP)**

• **Optohub Co., Ltd
Tomi-shi, Nagano 389-0512 (JP)**

(72) Inventors:
• **MAJIMA, Yatsuse
Kyoto, 604-8511 (JP)**
• **NAGUMO, Akira
Saitama, 336-0021 (JP)**
• **TAKANO, Hiroshi
Saitama, 336-0021 (JP)**

(74) Representative: **Müller-Boré & Partner
Patentanwälte PartG mbB
Friedenheimer Brücke 21
80639 München (DE)**

(54) **MAGNETIC DETECTION DEVICE**

(57)     This magnetic detection device (100) is provided with a plurality of magnetic sensor units (10) each including an excitation coil (12) and a signal coil (13) formed as conductor patterns on a board (40) and a magnetic core layer (11) arranged on the board. The magnetic detection device (100) is provided with a driving circuit (20) that outputs an AC current to an excitation coil (12) and a detection circuit (30) that acquires a detection signal from the signal coil (13). The signal coils (13) of the plurality of magnetic sensor units (10) are connected to each other.

FIG.1

# Description

## BACKGROUND OF THE INVENTION

### Field of the Invention

The present invention relates to a magnetic detection device, and more specifically to a magnetic detection device equipped with an excitation coil and a signal coil.

### Description of the Related Art

The following description sets forth the inventor's knowledge of the related art and problems therein and should not be construed as an admission of knowledge in the prior art.

Conventionally, a magnetic detection device equipped with an excitation coil and a signal coil is known. Such a device is disclosed, for example, in "Microfabricated Thin-Film Flux-Gate Magnetic Sensor and Its Applications," Shimadzu Hyoron, Shimadzu Hyoron Editorial Unit, August 1999, Vol. 56, No. 1 & 2, p. 19-28 authored by YOSHIMI and other five authors (hereinafter referred to as "Non-Patent Document 1") and Japanese Unexamined Patent Application Publication No. No. 2010-127889.

The above-described Non-Patent Document 1 describes a thin-film fluxgate magnetic sensor formed on a board. The thin-film fluxgate magnetic sensor described in the above-described Non-Patent Document 1 is equipped with a circular ring core, an excitation coil, and a receiving coil. The ring core is formed by a permalloy thin film on the board. Then, an upper wiring layer and a lower wiring layer made of thin pattern plating are laminated on top and bottom of a ring core via an insulating layer. The upper wiring layer and the lower wiring layer are connected to form an excitation coil and a receiving coil three-dimensionally around the ring core.

Further, the above-described Japanese Unexamined Patent Application Publication No. 2010-127889 discloses a so-called bulk-type fluxgate magnetic sensor in which an excitation winding and a detection winding are wound around an annular core made of a magnetic body. In the above-described Japanese Unexamined Patent Application Publication No. 2010-127889, the annular core is formed using a ring-shaped magnetic member formed by curving a columnar member.

Here, although the thin-film fluxgate magnetic sensor described in the above-described Non-Patent Document 1 is relatively small because the core and the coils are formed as thin films on a board, the winding number of the receiving coil (detection coil) becomes smaller as compared with the bulk type fluxgate magnetic sensor described in the above-described Japanese Unexamined Patent Application Publication No. 2010-127889, and therefore, the magnetic detection sensitivity becomes less sensitive.

On the other hand, in a so-called bulk-type fluxgate magnetic sensor, such as the fluxgate magnetic sensor described in Japanese Unexamined Patent Application Publication No. 2010-127889, the core and the coils (windings) are not formed as thin-films on a board. Therefore, the device size increases as compared with the fluxgate magnetic sensor configured on a board as described in the above-described Non-Patent Document 1. Therefore, it has been desired to increase the winding number of the receiving coil (signal coil) while suppressing the increase in the device size.

## SUMMARY OF THE INVENTION

The present invention has been made to solve the above-described problems. One object of the present invention is to provide a magnetic detection device capable of increasing the winding number of the signal coil while suppressing the increase in the device size.

A magnetic detection device according to one aspect of the present invention includes:

a plurality of magnetic sensor units each including an excitation coil and a signal coil formed as conductor patterns on a board and a magnetic core layer arranged on the board;
a driving circuit configured to output an AC current to the excitation coil, and
a detection circuit configured to acquire a detection signal from the signal coil,
wherein the signal coils of the plurality of magnetic sensor units are connected to each other.

In the magnetic detection device according to the above-described one aspect of the present invention, as described above, the signal coils of the plurality of magnetic sensor units are connected to each other. With this configuration, even in a case where a magnetic sensor unit including an excitation coil and a signal coil is formed on a board, the winding number of the signal coil can be increased by connecting the signal coils of the plurality of magnetic sensor units to each other. Further, since the excitation coil, the signal coil, and the magnetic core layer are formed on the board, it is possible to suppress the increase in the device size. As a result, it is possible to increase the winding number of the signal coil while suppressing the increase in the device size.

Further, the excitation coil, the signal coil, and the magnetic core layer are provided on each of the plurality of magnetic sensor units. Therefore, in the case of increasing the winding number of the signal coil by connecting the signal coils of the plurality of magnetic sensor units, it is possible to easily adjust the number and the arrangement of the plurality of magnetic sensor units. Therefore, it is possible to easily adjust the sensitivity, the detection region, and the shape of the entire magnetic detection device.

## BRIEF DESCRIPTION OF THE DRAWINGS

The preferred embodiments of the present invention are shown by way of example, and not limitation, in the accompanying figures.

FIG. 1 is a block diagram showing an entire configuration of a magnetic detection device according to a first embodiment of the present invention.
FIG. 2 is a schematic diagram showing a structure of one of a plurality of magnetic sensor units.
FIG. 3 is an enlarged cross-sectional view taken along the line III-III in FIG. 2.
FIG. 4 is a diagram showing an entire configuration of a magnetic detection device according to a second embodiment.
FIG. 5 is a schematic cross-sectional view along the X-Z plane of a magnetic detection device according to the second embodiment.
FIG. 6 is a diagram showing an entire configuration of a magnetic detection device according to a third embodiment.
FIG. 7 is a block diagram showing an entire configuration of a magnetic detection device according to a fourth embodiment of the present invention.
FIG. 8 is a schematic diagram for explaining a configuration of a magnetic convergence section.
FIG. 9 is a diagram for explaining a configuration of a magnetic convergence section according to a modification of the fourth embodiment of the present invention.

## DETAILED DESCRIPTION OF THE PREFERRED EMBODIMENTS

In the following paragraphs, some preferred embodiments of the present invention will be described by way of example and not limitation. It should be understood based on this disclosure that various other modifications can be made by those skilled in the art based on these illustrated embodiments.

Hereinafter, some embodiments in which the present invention is embodied will be described with reference to the attached drawings.

## [First Embodiments]

## (Configuration of Magnetic Detection Device)

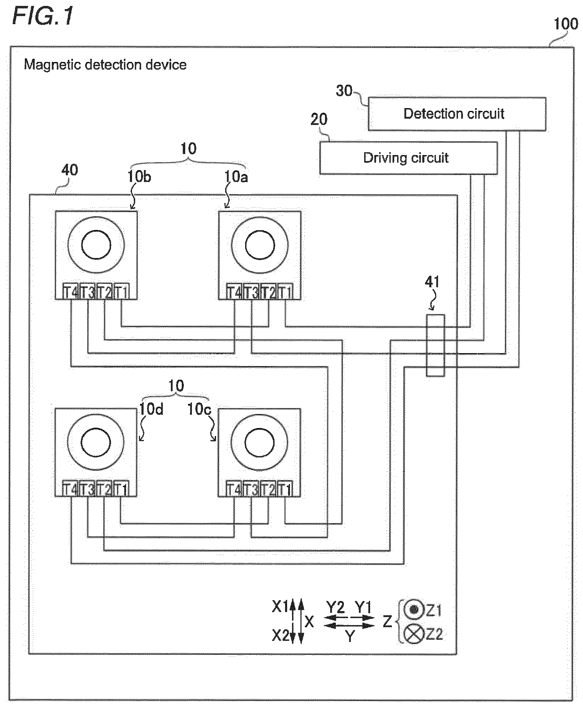

Referring to FIG. 1 to FIG. 3, an entire configuration of a magnetic detection device 100 according to a first embodiment of the present invention will be described.

As shown in FIG. 1, the magnetic detection device 100 according to the first embodiment is provided with a plurality of magnetic sensor units 10, a driving circuit 20, and a detection circuit 30.

## <Magnetic Sensor Unit>

The plurality of magnetic sensor units 10 includes, for example, four magnetic sensor units, i.e., the magnetic sensor unit 10a, the magnetic sensor unit 10b, the magnetic sensor unit 10c, and the magnetic sensor unit 10d. Note that the four magnetic sensor units, i.e., the magnetic sensor unit 10a, the magnetic sensor unit 10b, the magnetic sensor unit 10c, and the magnetic sensor unit 10d, each have a mutually common configuration. In the following description, the configuration common to the four magnetic sensor units, i.e., the magnetic sensor unit 10a, the magnetic sensor unit 10b, the magnetic sensor unit 10c, and the magnetic sensor unit 10d, will be described as "magnetic sensor unit 10" without distinction.

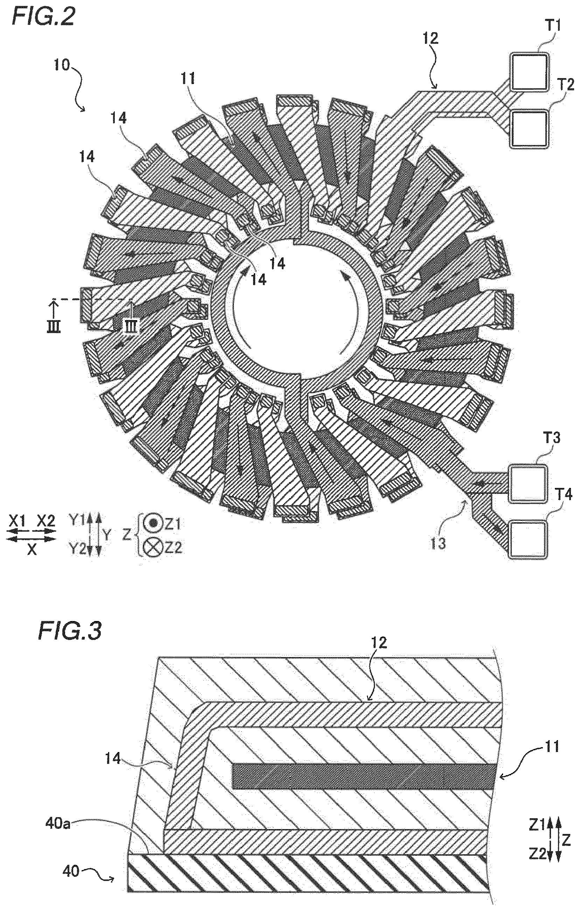

As shown in FIG. 2, the plurality of magnetic sensor units 10 each has a ring core 11, an excitation coil 12, and a signal coil 13. Each of the plurality of magnetic sensor units 10 is a fluxgate magnetic sensor. The ring core 11, the excitation coil 12, and the signal coil 13 are arranged on the board 40 (see FIG. 1). Each of the plurality of magnetic sensor units 10 is a sensor independent for each ring core 11. Note that, in FIG. 2, the ring core 11, the excitation coil 12, and the signal coil 13 are distinguishably illustrated by differentiating the hatching. Further note that the ring core 11 is one example of the "magnetic core layer" recited in claims.

The ring core 11 has an annular shape. The ring core 11 is arranged along a main surface 40a (see FIG. 3) of a board 40, as a layer formed on the board 40. In other words, the ring core 11 is formed as a thin magnetic body layer on the board 40. The ring core 11 is made of a soft magnetic material forming a magnetic path serving as a magnetic flux path. The ring core 11 is, for example, a permalloy thin film. The ring core 11 is formed in an annular shape, for example, by sputter deposition and etching on the board 40.

Note that the ring core 11 may be made of, in addition to the above-described permalloy thin film, a supermalloy containing Fe (iron), Ni (nickel), Mo (molybdenum), etc., an amorphous material containing Co (cobalt), Fe, etc., or a randomly oriented amorphous alloy by partially crystallizing it into a nanocrystalline material, etc.

Further, the excitation coil 12 and the signal coil 13 are arranged along the circumferential direction of the annular ring core 11 while alternately winding around the ring core 11. The signal coil 13 is arranged while switching the winding direction on the ring core 11 every half circumference of the ring core 11. The signal coil 13 is wound in different directions from each other on the X1-direction side and the X2-direction side with respect to the center of the ring core 11. The winding direction (direction in which it is wound) of the signal coil 13 is indicated by an arrow in the figure. In the signal coil 13, on the X1-direction side, it is wound from the radially inner side of the ring core 11 to the radially outer side of the ring core 11 on the Z1-direction side.

On the other hand, the X2-direction side portion of the signal coil 13 is wound from the radially outer side of the ring core 11 in the Z1-direction side toward the radially inner side of the ring core 11. The signal coil 13 is in a differentially connected state in which the X1-direction side portion and the X2-direction side portion are differentiated in polarity from each other.

The excitation coil 12 is connected to the driving circuit 20 via a terminal T1 and a terminal T2. Further, the signal coil 13 is connected to the detection circuit 30 via a terminal T3 and a terminal T4.

As shown in FIG. 3, the excitation coil 12 and the signal coil 13 are formed as thin-film conductor patterns on the board 40. Note that FIG. 3 is an enlarged cross-sectional view taken along the line III-III in FIG. 2, and therefore shows the cross-section of the excitation coil 12, and the structure of the signal coil 13 is also similar. The excitation coil 12 and the signal coil 13 are arranged on the board 40 so as to wind around the ring core 11 by connecting the conductor pattern formed on one side (Z1-direction side) in the direction (thickness direction) intersecting the main surface 40a of the board 40 and the conductor pattern formed on the other side (Z2-direction side) so as to sandwich the ring core 11 with one another.

For example, in the excitation coil 12 and the signal coil 13, the conductor pattern formed on the Z1-direction side and the conductor pattern formed on the Z2-direction side are connected to each other via a contact hole (portion 14 in FIG. 2 and FIG. 3). The excitation coil 12 and the signal coil 13 are formed, for example, by copper pattern plating. In each of the plurality of magnetic sensor units 10, the Z2-direction side conductor patterns of the excitation coil 12 and the signal coil 13 are formed on the board 40, and then a layer of the ring core 11 is formed after arranging an insulating film. Thereafter, the insulation film is placed again, and then the conductor patterns of the excitation coil 12 and the signal coil 13 on the Z1-direction side and the conductors of the contact holes are formed. As described above, the excitation coil 12 and the signal coil 13 are arranged so as to wind around the ring core 11 three-dimensionally.

Note that in FIG. 2, the portion 14 connecting the conductor patterns of the excitation coil 12 and the signal coil 13 on the Z1-direction side and the conductor patterns of the excitation coil 12 and the signal coil 13 on the Z2-direction side to each other is shown in a shifted state, as viewed from the Z-direction side. However, it may be configured such that the part of the portion 14 to be connected on the Z1-direction side and the part of the portion 14 to be connected on the Z2-direction side are arranged so as to overlap each other as viewed from the Z-direction side.

Note that since the plurality of magnetic sensor units 10 (the magnetic sensor unit 10a to the magnetic sensor unit 10d) has a common configuration, the excitation coils 12 of the plurality of magnetic sensor units 10 (the magnetic sensor unit 10a to the magnetic sensor unit 10d) have a mutually common winding number. Similarly, the signal coils 13 of the plurality of magnetic sensor units 10 (the magnetic sensor unit 10a to the magnetic sensor unit 10d) also have a mutually common winding number. Further, the plurality of magnetic sensor units 10 each have a shape in which the size in a direction (Z-direction) intersecting the main surface 40a of the board 40 is smaller than the size in a direction (along the XY-direction) along the main surface 40a of the board 40.

As shown in FIG. 1, the driving circuit 20 outputs an AC current to the excitation coil unit 12. The driving circuit 20 includes, for example, an oscillator and outputs an excitation current, which is an AC current of a predetermined frequency, to the excitation coil 12 via the terminal T1 and the terminal T2. The excitation current is, for example, a triangular wave AC current. The magnitude of the excitation current is large enough to saturate the magnetic field generated in the ring core 11 by the excitation current.

Further, the detection circuit 30 acquires a detection signal from the signal coil 13. The detection circuit 30 acquires a detection signal from the signal coil 13 via the terminal T3 and the terminal T4. The ring core 11 becomes a state in which the magnetic flux is saturated periodically while reversing the polarity alternately by the AC current (excitation current) flowing through the excitation coil 12. In the signal coil 13, an induced electromotive force is generated at the timing when the polarity of the ring core 11 is switched. In the signal coil 13, at the timing when the magnetic flux is saturated in the ring core 11, no induced electromotive force is generated because the magnetic flux does not change. Therefore, in the signal coil 13, a pulse induced electromotive force that alternately switches the direction (polarity) is generated with a period twice the AC current flowing through the excitation coil 12.

Here, in the signal coil 13, the X1-direction side portion and the X2-direction side portion are differentially connected in opposite polarity, so that in the absence of an external magnetic field (magnetic field), the induced electromotive forces generated in the signal coil 13 cancel each other. In this case, the detection signal output from the signal coil 13 becomes zero. On the other hand, when an external magnetic field along the Y-direction is input, the timing at which the magnetic flux in the ring core 11 saturates differs from each other between the part on the X1-direction side and the part on the X2-direction side.

Specifically, it becomes a state in which a magnetic field of a DC component is applied to the ring core 11 from the outside, and therefore, the timing at which an induced electromotive force is generated changes so as to differ between the X1-side portion and the X2-side portion of the signal coil 13 depending on the magnitude of the magnetic field from the outside. Although the X1-side portion of the signal coil 13 and the X2-side portion of the signal coil 13 differ in polarity from each other, the induced electromotive forces do not cancel each other due to the different timings, which generates a voltage signal having twice the frequency of the excitation current, as a detection signal.

The detection circuit 30 has, for example, a synchronous rectifier and an integrator. The detection circuit 30 synchronously rectifies the detection signal generated in the signal coil 13 and then integrates it to output a detection value corresponding to the magnitude of the external magnetic field input in the Y-direction. As described above, in each of the plurality of magnetic sensor units 10, the Y-direction, which is a direction along a line passing the positions where the winding direction of the signal coil 13 is changed in the ring core 11, becomes a detection direction.

In the magnetic detection device 100, for example, an AC current (excitation current) is output from the driving circuit 20 based on the signal from the control unit, which is not shown in the figure and includes an arithmetic unit such as a CPU (Central Processing Unit), and a signal indicating the detection value corresponding to the magnitude of the external magnetic field based on the detection signal from the detection circuit 30 is output to the controller. The detection value acquired by the controller is displayed on a display unit, such as a display monitor, which is not illustrated in the figure.

**<Connection Between a Plurality of Magnetic Sensor Units>**

As shown in FIG. 1, in the first embodiment, the signal coils 13 of the plurality of magnetic sensor units 10 (the magnetic sensor unit 10a to the magnetic sensor unit 10d) are connected to each other. Further, the excitation coils 12 of the plurality of magnetic sensor units 10 are connected to each other.

Specifically, the excitation coils 12 of the plurality of magnetic sensor units 10 are connected in series in the forward direction equal in polarity. In the plurality of magnetic sensor units 10, the terminal T1 of the magnetic sensor unit 10a is connected to the driving circuit 20, and the terminal T2 of the magnetic sensor unit 10a and the terminal T1 of the magnetic sensor unit 10b are connected to each other. The terminals T2 of the magnetic sensor unit 10b and the terminal T1 of the magnetic sensor unit 10c are connected to each other. Similarly, the terminal T2 of the magnetic sensor unit 10c and the terminal T1 of the magnetic sensor unit 10d are connected to each other. The terminal T2 of the magnetic sensor unit 10d is connected to the driving circuit 20.

In other words, the excitation coils 12 of the plurality of magnetic sensor units 10 are configured to flow an AC current output from the common driving circuit 20. Therefore, in the excitation coils 12 of the plurality of magnetic sensor units 10, each of the period, the phase, and the polarity of the flowing AC current is common to each other. Therefore, in each of the plurality of magnetic sensor units 10, an oscillating magnetic flux with a common period, phase, and polarity is generated in the ring core 11.

Similarly, the signal coils 13 of the plurality of magnetic sensor units 10 are connected in series in the forward direction. In the plurality of magnetic sensor units 10, the terminal T3 of the magnetic sensor unit 10a is connected to the detection circuit 30, and the terminal T4 of the magnetic sensor unit 10a and the terminal T3 of the magnetic sensor unit 10b are connected to each other. The terminals T4 of the magnetic sensor unit 10b and the terminal T3 of the magnetic sensor unit 10c are connected to each other. Similarly, the terminal T4 of the magnetic sensor unit 10c and the terminal T3 of the magnetic sensor unit 10d are connected to each other. The terminal T4 of the magnetic sensor unit 10d is connected to the detection circuit 30.

In other words, the detection signals from the signal coils 13 of the plurality of magnetic sensor units 10 are detected by the common detection circuit 30 collectively. When viewed from the detection circuit 30, the signal coils 13 of the plurality of magnetic sensor units 10 are considered to be similar to a single coil collectively.

Further, in the first embodiment, the plurality of magnetic sensor units 10 (the magnetic sensor unit 10a to the magnetic sensor unit 10d) is arranged side by side along the main surface 40a of the board 40. The plurality of magnetic sensor units 10 is arranged with their detection directions aligned with a common direction. Specifically, each of the plurality of magnetic sensor units 10 is arranged with the detection direction aligned with the Y-direction. The four of the magnetic sensor unit 10a to the magnetic sensor unit 10d are arranged two by two in a grid pattern.

In other words, the magnetic sensor unit 10a and the magnetic sensor unit 10b are arranged side by side so as to be adjacent to each other in the Y-direction, which is the detection direction. The magnetic sensor unit 10c and the magnetic sensor unit 10d are arranged to be adjacent to the magnetic sensor unit 10a and the magnetic sensor unit 10b, respectively, in the X-direction. As described above, independently configured magnetic sensor units 10 are arranged side by side on the board 40 in a mutually connected manner.

Further, the excitation coil and the signal coil of each of the plurality of magnetic sensor units are formed as conductor patterns on a common board. In other words, on one board 40, the excitation coil 12 and the signal coil 13 of each of the plurality of magnetic sensor units 10 are formed. Further, the conductors connecting the plurality of magnetic sensor units 10 may also be formed as conductor patterns on the board 40. In such a case, the conductor pattern forming the excitation coil 12 and the signal coil 13 and the conductor pattern of the board 40 may be formed integrally, or the conductor pattern of the board 40 and the terminals T1 to T4 of the plurality of magnetic sensor units 10 may be electrically connected to each other by soldering conductor wires (lead wires) or the like.

The excitation coil 12 and the signal coil 13 of each of the plurality of magnetic sensor units 10 are connected to the driving circuit 20 and the detection circuit 30, respectively, via a connector 41 provided on the board 40. The driving circuit 20 and the detection circuit 30 are configured, for example, in a common hybrid IC (HIC). The driving circuit 20 and the detection circuit 30 may be arranged on the board 40, or they may be arranged at locations different from the board 40.

Note that the S/N ratio (signal-to-noise ratio) is improved by connecting the plurality of signal coils 13 in series with each other. Specifically, when the detection signal intensity of one signal coil 13 is Vs and the noise signal intensity is Vn, the S/N ratio is expressed as Vs/Vn. In a case where the N pieces of signal coils 13 is connected in series, the intensity of the detection signal is Vs•N by the Faraday's law. On the other hand, the intensity of the noise signal is represented by the intensity (voltage value) of the thermal noise and is shown by Equation (1).

$$Vn = \sqrt{4kTRB} \quad \cdots (1)$$

(k: Boltzmann's constant, T: absolute temperature, R: resistance, B: bandwidth)

Here, the resistance value R is proportional to the winding number, and the Boltzmann constant k, the absolute temperature T, and the bandwidth B are constant. Therefore, when N pieces of signal coils 13 are connected in series, the winding number becomes N times and the resistance value R also becomes N times, so the intensity Vn of the noise signal is multiplied by $\sqrt{N}$. Therefore, the S/N ratio when N pieces of signal coils 13 are connected in series is expressed by Equation (2).

$$\frac{Vs \cdot N}{Vn \cdot \sqrt{N}} = \sqrt{N} \frac{Vs}{Vn} \quad \cdots (2)$$

Thus, when N pieces of the signal coils 13 are connected in series, the S/N ratio improves by $\sqrt{N}$ times.

**(Effects of First Embodiment)**

In this first embodiment, the following effects can be obtained.

In the first embodiment, as described above, the signal coils 13 of the plurality of magnetic sensor units 10 are connected to each other. With this configuration, even in a case where the magnetic sensor unit 10 including the excitation coil 12 and the signal coil 13 is formed on the board 40, the winding number of the signal coil 13 can be increased by connecting the signal coils 13 of the plurality of magnetic sensor units 10 to each other. Further, since the excitation coil 12, the signal coil 13, and the ring core 11 (magnetic core layer) are formed on the board 40, it is possible to suppress the increase in the device size. As a result, it is possible to increase the winding number of the signal coil 13 while suppressing the increase in the device size.

Further, the excitation coil 12, the signal coil 13, and the ring core 11 (magnetic core layer) are provided on each of the plurality of magnetic sensor units 10. Therefore, in the case of increasing the winding number of the signal coil 13 by connecting the signal coils 13 of the plurality of magnetic sensor units 10, it is possible to easily adjust the number and the arrangement of the plurality of magnetic sensor units 10. Therefore, it is possible to easily adjust the sensitivity, the detection region, and the shape of the entire magnetic detection device 100.

Further, in the above-described first embodiment, the following further effects can be obtained by configuring as follows.

That is, in other words, in the first embodiment, as described above, the excitation coils 12 of the plurality of magnetic sensor units 10 are connected to each other and are configured to flow an AC current output from the common driving circuit 20. By configuring as described above, it is possible to suppress the device configuration from becoming more complex and the increase in size of the device as compared with the case in which a separate driving circuit 20 is provided for each of the plurality of magnetic sensor units 10.

Further, in the first embodiment, as described above, the ring core 11 (magnetic core layer) has an annular shape and is arranged as a layer formed on the board 40 along the main surface 40a of the board 40. The excitation coil 12 and the signal coil 13 are arranged so as to wind around the ring core 11 by connecting the conductor pattern formed on one side (Z1-direction side) in the direction intersecting the main surface 40a of the board 40 and the conductor pattern formed on the other side (Z2-direction side) to each other so as to sandwich the ring core 11.

By configuring as described above, in the case of forming the excitation coil 12 and the signal coil 13 to wind around the ring core 11, by forming the coil as a conductor pattern on the board 40, the size in the direction intersecting the main surface 40a of the board 40 (thickness direction: Z-direction) can be reduced. Therefore, even in the case of providing a plurality of magnetic sensor units 10, it is possible to suppress the size of the board 40 in the thickness direction.

Furthermore, in the first embodiment, as described above, the excitation coil 12 and the signal coil 13 are arranged to wind alternately around the ring core 11 (magnetic core layer) along the circumferential direction of the annular shaped ring core 11. The signal coil 13 is arranged while changing the winding direction every half circumference of the ring core 11. The plurality of magnetic sensor units 10 is arranged with the detection direction aligned with a mutually common direction (Y-direction), the detection direction being a direction of a line passing the positions where the winding direction of the signal coil 13 is changed in the ring core 11.

By configuring as described above, the plurality of magnetic sensor units 10 is arranged with the detection directions aligned with a mutually common direction. Therefore, by connecting the signal coils 13 of the plurality of magnetic sensor units 10 to each other, the sensitivity can be effectively improved.

Furthermore, in the first embodiment, as described above, the plurality of magnetic sensor units 10 is arranged side by side along the main surface 40a of the board 40. By configuring as described above, as compared with the case in which only one magnetic sensor unit 10 is provided, it is possible to increase the detection range in a direction along the main surface 40a of the board 40 by the amount that the plurality of magnetic sensor units 10 are arranged side by side. Furthermore, by arranging the plurality of magnetic sensor units 10 along the main surface 40a of the board 40, it is possible to reduce the size in the direction intersecting the main surface 40a of the board 40 (in the thickness direction).

Furthermore, in the first embodiment, as described above, the excitation coil 12 and the signal coil 13 of each of the plurality of magnetic sensor units 10 are formed as conductor patterns on the common board 40. By configuring as described above, as compared with the case in which the excitation coil 12 and the signal coil 13 of each of the plurality of magnetic sensor units 10 are formed on separate boards for each magnetic sensor unit 10, the plurality of magnetic sensor units 10 can be produced by processing them together on the common board 40. Therefore, the production process can be simplified.

Furthermore, in the first embodiment, as described above, the excitation coils 12 of the plurality of magnetic sensor units 10 have a common winding number, and the signal coils 13 of the plurality of magnetic sensor units 10 have a common winding number. By configuring as described above, each of the plurality of magnetic sensor units 10 can be produced by a common process as compared with the case in which the excitation coil 12 and the signal coil 13 different in winding numbers are used. In this respect, the production process can be simplified.

**[Second Embodiment]**

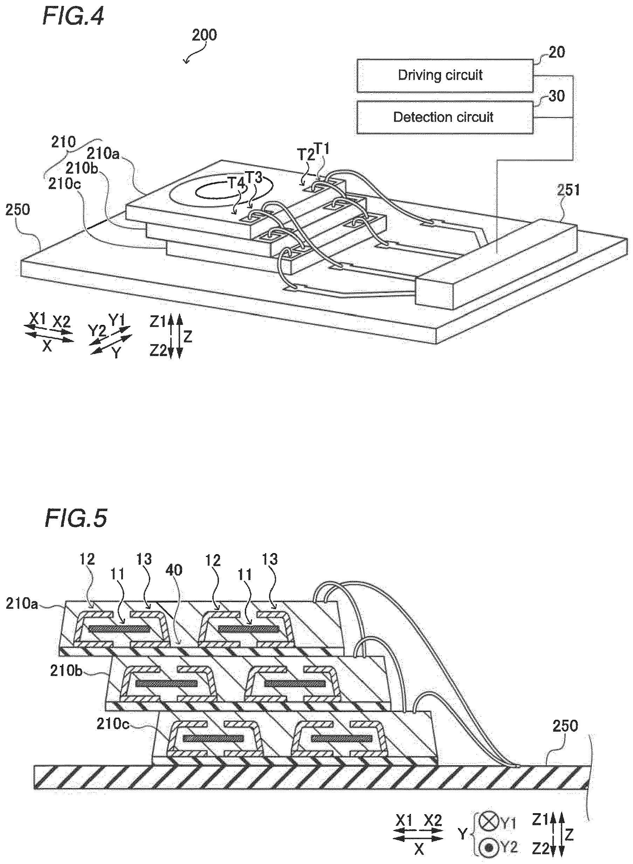

Referring to FIG. 4 and FIG. 5, a second embodiment is described. In this second embodiment, unlike the first embodiment in which the plurality of magnetic sensor units 10 is arranged along the main surface 40a of the board 40, the plurality of magnetic sensor units 210 is arranged in a stacked manner. Note that in the figure, the same symbol is assigned to the portion with the same configuration as in the above-described first embodiment.

**(Configuration of Magnetic Detection Device According to Second Embodiment)**

As shown in FIG. 4, the magnetic detection device 200 according to the second embodiment is equipped with a plurality of magnetic sensor units 210. The plurality of magnetic sensor units 210 includes, for example, three of the magnetic sensor unit 210a, the magnetic sensor unit 210b, and the magnetic sensor unit 210c. The three of the magnetic sensor unit 210a, the magnetic sensor unit 210b, and the magnetic sensor unit 210c have a common configuration. Furthermore, each of the three of the magnetic sensor unit 210a, the magnetic sensor unit 210b, and the magnetic sensor unit 210c includes a ring core 11, an excitation coil 12, and a signal coil 13 formed on a board 40, similar to the plurality of magnetic sensor units 10 in the first embodiment.

As shown in FIG. 5, in the second embodiment, each of the plurality of magnetic sensor units 210 is arranged to be stacked. Specifically, the plurality of magnetic sensor units 210 is arranged so that boards 40 each including the ring core 11, the excitation coil 12, and the signal coil 13 are stacked along the direction (thickness direction: Z-direction) intersecting the main surface 40a of the board 40.

For example, three of the magnetic sensor unit 210a, the magnetic sensor unit 210b, and the magnetic sensor unit 210c are arranged in this order from the top (from the Z1-direction side) on the placement board 250, which is separate from the boards 40 constituting the respective magnetic sensor units 210. The plurality of magnetic sensor units 210 is connected to a conductor pattern formed on the placement board 250. The terminal T1 to the terminal T4 of the plurality of magnetic sensor units 210 are electrically connected to the conductor pattern of the board 250 by soldering conducting wires (lead wires).

Note that the terminal T1 to the terminal T4 of the plurality of magnetic sensor units 210 may be electrically connected to the conductor pattern of the board 250 by using a wire bonding method. Furthermore, a driving circuit 20 and a detection circuit 30 are connected to conductor patterns formed on the board 250 via a connector 251 formed on the board 250 for placement.

The plurality of magnetic sensor units 210 is connected in series with each other as in the first embodiment. In other words, the excitation coils 12 of the plurality of magnetic sensor units 210 are connected in series with each other, and the signal coils 13 are connected in series with each other as well.

Specifically, as shown in FIG. 4, in the plurality of magnetic sensor units 210, the terminal T1 of the magnetic sensor unit 210a is connected to the driving circuit 20 via the conductor pattern and the connector 251 on the board 250. The terminals T2 of the magnetic sensor unit 210a and the terminal T1 of the magnetic sensor unit 210b are connected to each other. The terminals T2 of the magnetic sensor unit 210b and the terminal T1 of the magnetic sensor unit 210c are connected to each other. The terminal T2 of the magnetic sensor unit 210c is connected to the driving circuit 20 via the conductive pattern of the board 250 and the connector 251.

Further, the terminal T3 of the magnetic sensor unit 210a is connected to the detection circuit 30 via the conductor pattern of the board 250 and the connector 251. The terminals T4 of the magnetic sensor unit 210a and the terminal T3 of the magnetic sensor unit 210b are connected to each other. The terminals T4 of the magnetic sensor unit 210b and the terminal T3 of the magnetic sensor unit 210c are connected to each other. The terminal T4 of the magnetic sensor unit 210c is connected to the detection circuit 30 connected to the detection circuit 30 via the conductor pattern of the board 250 and the connector 251.

Note that the plurality of magnetic sensor units 210 is stacked with the detection direction aligned with the Y-direction. The plurality of magnetic sensor units 210 may be stacked with the detection direction aligned with the X-direction. Further, the plurality of magnetic sensor units 210 is arranged to be stacked while shifting the arrangement in a stair-like fashion to connect the terminals to each other.

Note that the other configuration of the magnetic detection device 200 according to the second embodiment is the same as in the first embodiment described above.

(Effects of Second Embodiment)

In the second embodiment, the following effects can be obtained.

In the second embodiment, as described above, the plurality of magnetic sensor units 210 is arranged so that boards 40 each including the excitation coil 12, the signal coil 13, and the ring core 11 (magnetic core layer) are stacked along the direction (Z direction) intersecting the main surface 40a of the board 40.

By configuring as described above, it is possible to improve the sensitivity of the magnetic detection device 200 including the plurality of magnetic sensor units 210 while suppressing the increase in size in a direction along the main surface 40a of the board 40. Further, each of the plurality of magnetic sensor units 210 each constituted by the board 40 has a flat shape whose size in the direction (Z-direction) intersecting the main surface 40a of the board 40 is smaller than the size in the direction (the direction along the XY-plane) along the main surface 40a of the board 40. Therefore, by stacking them along the direction intersecting the main surface 40a of the board 40, the plurality of magnetic sensor units 210 can be arranged in a concentrated manner in a smaller area, and therefore, it is possible to improve the resolution of the magnetism detection in a smaller detection range.

Note that the other effects of the second embodiment are the same as that in the first embodiment.

[Third Embodiment]

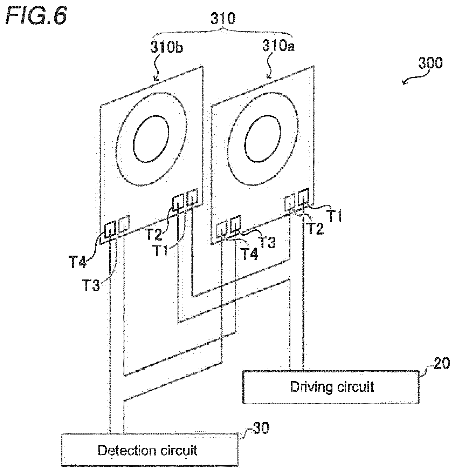

Referring to FIG. 6, a third embodiment will be described. In this third embodiment, the signal coils 13 of the pair of magnetic sensor units 310a and 310b are connected so that the signal coils 13 of the pair of magnetic sensor units are opposite in polarity. Note that in the figure, the same reference symbol is assigned to the portion with the same configuration as in the above-described first embodiment.

(Configuration of Magnetic Detection Device According to Third Embodiment)

As shown in FIG. 6, the magnetic detection device 300 according to the third embodiment is equipped with a plurality of magnetic sensor units 310. The plurality of magnetic sensor units 310 includes, for example, the magnetic sensor unit 310a and the magnetic sensor unit 310b. The magnetic sensor unit 310a and the magnetic sensor unit 310b have a mutually common configuration. Furthermore, the configuration of each of the plurality of magnetic sensor units 310 is the same as that of each of the plurality of magnetic sensor units 10 according to the first embodiment.

Note that the magnetic sensor unit 3 10a is one example of the "first magnetic sensor unit" recited in claims. Further, the magnetic sensor unit 310b is one example of the "second magnetic sensor unit" recited in claims.

In the third embodiment, the magnetic sensor unit 310a and the magnetic sensor unit 310b are connected in series in the forward direction in which the excitation coil 12 are equal in polarity. The signal coils 13 are connected in series in the opposite direction in which the signal coils units are different in polarity from each other.

That is, the terminal T1 of the magnetic sensor unit 3 10a is connected to the driving circuit 20, and the terminal T2 of the magnetic sensor unit 310a is connected to the terminal T1 of the magnetic sensor unit 310b. The terminal T2 of the magnetic sensor unit 310b is connected to the driving circuit 20. On the other hand, the terminal T3 of the magnetic sensor unit 3 10a is connected to the terminal T3 of the magnetic sensor unit 310b. The terminal T4 of the magnetic sensor unit 310a and the terminal T4 of the magnetic sensor unit 310b are connected to the detection circuit 30.

Therefore, in each of the magnetic sensor unit 310a and the magnetic sensor unit 310b, a common AC current flows through the excitation coil 12 in the forward direction, as in the first and second embodiments. As in the first and second embodiments, in each of the magnetic sensor unit 310a and the magnetic sensor unit 310b, magnetic fluxes with a common period, phase, and polarity are produced in the ring core 11.

On the other hand, in the magnetic sensor unit 310a and the magnetic sensor unit 310b, the terminals T3 are connected to each other, and therefore, in the case where the magnetic fields externally applied to the magnetic sensor unit 3 10a and 3 10b are common, the outputs from the signal coils 13 cancel each other. When there is a difference in the magnetic fields applied externally to the magnetic sensor unit 310a and the magnetic sensor unit 310b, a detection signal indicating the magnitude of the difference is output to the detection circuit 30. The magnetic detection device 300 is configured as a gradiometer that cancels magnetic noise from the surrounding environment, such as geomagnetism, and detects the magnetic gradient between the two of the magnetic sensor unit 310a and the magnetic sensor unit 310b.

Note that the magnetic sensor unit 310a and the magnetic sensor unit 310b may be arranged side by side along the main surface 40a of the board 40, or may be arranged in a stacked manner along the direction intersecting the main surface 40a of the board 40. Further, the other configurations of the magnetic detection device 300 according to the third embodiment are the same as in the above-described first and second embodiments.

**(Effects of Third Embodiment)**

In the third embodiment, the following effects can be obtained.

In the third embodiment, as described above, the plurality of magnetic sensor units 310 includes a magnetic sensor unit 310a (first magnetic sensor unit) and a magnetic sensor unit 310b (second magnetic sensor unit). The magnetic sensor unit 310a and the magnetic sensor unit 310b are connected in series in the forward direction in which the excitation coils 12 are equal in polarity. The signal coils 13 are connected in series in the reverse direction in which the polarity is different from each other.

By configuring as described above, since a gradiometer in which the two signal coils 13 are connected to each other with reverse polarity can be configured using two magnetic sensor units 310a and 310b formed on the board 40, even in the case of configuring a gradiometer in which two magnetic sensor units 310 connected to each other with reverse polarity, the device size configuration can be reduced.

Furthermore, the two magnetic sensor units 310a and 310b formed on the board 40 have a flattened shape in which the size in the direction intersecting the main surface 40a of the board 40 is smaller than the size in the direction along the main surface 40a of the board 40. And since the detection direction is a direction (Y-direction) along the main surface 40a of the board 40, the gradiometer can be configured by arranging a plurality of magnetic sensor units 310 in a stacked manner along the direction intersecting the main surface 40a of the board 40. Therefore, a plurality of magnetic sensor units 310 can be arranged in a narrow pitch, and therefore, it is possible to improve the spatial resolution when the gradiometer is configured.

Note that the other effects of the third embodiment are the same as those in the first and second embodiments.

**[Fourth Embodiment]**

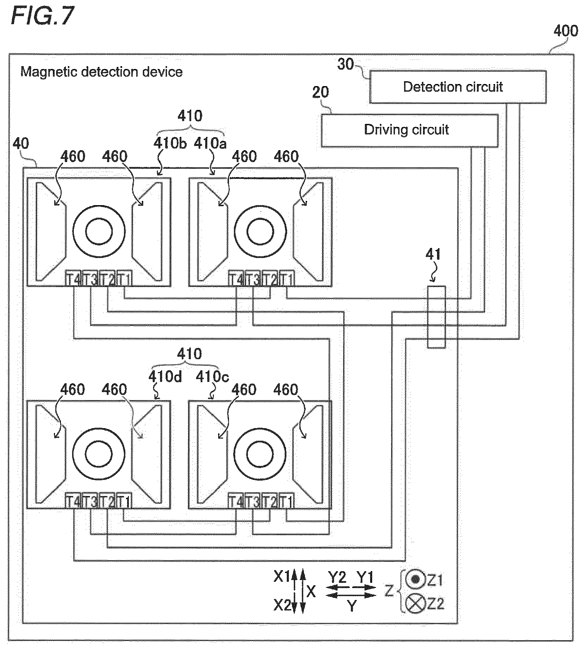

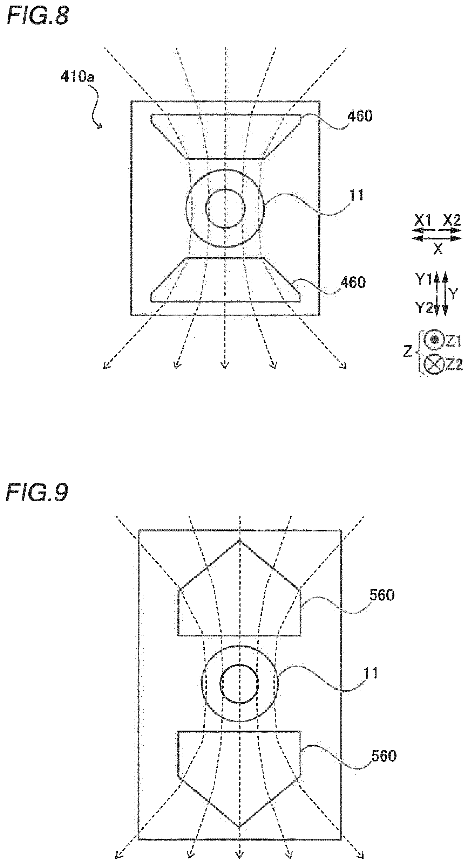

Referring to FIG. 7 and FIG. 8, a fourth embodiment will be described. In this fourth embodiment, a magnetic convergence section 460 is provided for each of the plurality of magnetic sensor units 410. Note that in the figure, the same reference symbol is assigned to the portion with the same configuration as in the above-described first embodiment.

**(Configuration of Magnetic Detection Device According to Fourth Embodiment)**

As shown in FIG. 7, the magnetic detection device 400 according to the fourth embodiment is provided with a plurality of magnetic sensor units 410, i.e., a magnetic sensor unit 410a, a magnetic sensor unit 410b, a magnetic unit 410c, and a magnetic sensor unit 410d. Each of the plurality of magnetic sensor units 410 has a mutually common configuration. Further, each of the plurality of magnetic sensor units 410 includes a ring core 11, an excitation coil 12, and a signal coil 13, similar to each of the plurality of magnetic sensor units 10 (magnetic sensor units 10a to 10d) in the first embodiment.

The plurality of magnetic sensor units 410 (the magnetic sensor unit 410a to the magnetic sensor unit 410d) is connected in series with each other as in the first embodiment. In other words, in each of the plurality of magnetic sensor units 410, as in the plurality of magnetic sensor units 10 of the first embodiment, the excitation coils 12 of the plurality of magnetic sensor units 410 are connected in series with each other, and the signal coils 13 are connected in series with each other as well.

Further, as in the first embodiment, the plurality of magnetic sensor units 410 is arranged along the main surface of the board 40 with the detection directions aligned with a common direction. Further, the excitation coils 12 and the signal coils 13 of the plurality of magnetic sensor units 410 are arranged as conductor patterns on the common board 40.

And in the fourth embodiment, the magnetic detection device 400 is provided with a magnetic convergence section 460 that converges the magnetic flux with respect to the ring core 11 of each of the plurality of magnetic sensor units 410 (magnetic sensor units 410a to 410d). Two of the magnetic convergence sections 460 are arranged for each of the plurality of magnetic sensor units 410.

Note that the magnetic convergence section 460 in each of the plurality of magnetic sensor units 410 has the same configuration. In the following description, the magnetic convergence section 460 in the magnetic sensor unit 410a of each of the plurality of magnetic sensor units 410 is illustrated and described, and the magnetic convergence sections 460 in each of the magnetic sensor units 410b to 410f will be omitted.

As shown in FIG. 8, in the fourth embodiment, the magnetic convergence section 460 is arranged on the detection direction side of the ring core 11 (magnetic core layer) in each of the plurality of magnetic sensor units 410. For example, in the magnetic sensor unit 410a, the magnetic convergence section 460 is arranged along the detection direction (along the sensitivity axis passing through the center of the ring core 11) on each of one side (Y1-direction side) and the other side (Y2-direction side) of the ring core 11 in the Y-direction, with respect to the ring core 11.

The magnetic convergence section 460 is, for example, a magnetic body layer of a thin film formed along the main surface of the board 40, in the same manner as the ring core 11. The magnetic convergence section 460 is made of a soft magnetic material forming a magnetic path. For example, the magnetic convergence section 460 is a permalloy thin film. The magnetic convergence section 460 is formed by sputter deposition and etching on the board 40, in the same manner as the ring core 11. Note that the magnetic convergence section 460 is arranged at the position equal to that of the ring core 11 in the thickness direction of the board 40.

The magnetic convergence section 460 is a trapezoidal thin film. In the magnetic convergence section 460, the length of the side in the direction away from the ring core 11 along the detection direction is larger than the length of the side in the direction proximate to the ring core 11. As a result, in the magnetic convergence section 460, the magnetic flux from the side in the direction away from the ring core 11 along the detection direction is converged along the detection direction and output from the side in the direction close to the ring core 11.

In other words, the magnetic convergence section 460 increases the magnetic flux density in each of the plurality of magnetic sensor units 410 (the magnetic sensor unit 410a to the magnetic sensor unit 410f) by the lensing action of magnetism. For example, the magnetic convergence section 460 converges the magnetic flux input to the ring core 11 of the magnetic sensor unit 410a. The magnetic convergence section 460 converges the magnetic field (magnetic flux) oriented along the detection direction (Y-direction) around the ring core 11 toward the ring core 11. In other words, the magnetic convergence section 460 converges the magnetic flux passing through the position outside the ring core 11 in the X-direction so that it passes through the ring core 11.

Note that the other configuration of the magnetic detection device 400 according to the fourth embodiment is the same as that in the first to third embodiments described above.

**(Effects of Fourth Embodiment)**

In the fourth embodiment, the following effects can be obtained.

In the fourth embodiment, as described above, the magnetic detection device 400 has a magnetic convergence section 460 arranged on the detection direction side of the ring core 11 (magnetic core layer) in the plurality of magnetic sensor units 410 (the magnetic sensor unit 410a to the magnetic sensor unit 410f) and converges the magnetic flux to the ring core 11.

By configuring as described above, the magnetic flux can be converged with respect to the ring core 11 by the magnetic convergence section 460, and therefore, the sensitivity of detection in each of the plurality of magnetic sensor units 410a to 410f can be further improved. For this reason, in the case of detecting magnetic fields in a plurality of directions, the detection positions for each of the magnetic fields in the plurality of directions can be brought closer to each other while suppressing the reduction in sensitivity.

Note that the other effects of the fourth embodiment are the same as those in the first and third embodiments.

**<Modifications>**

Note that the embodiments disclosed here should be considered illustrative and not restrictive in all respects. It should be noted that the scope of the present invention is indicated by claims and is intended to include all modifications (modified examples) within the meaning and scope of the claims and equivalents.

For example, in the first and second embodiments described above, an example is shown in which the signal coils 13 of the plurality of magnetic sensor units 10 (210) are connected in series in the forward direction with respect to the detection circuit 30, but the present invention is not limited thereto.

In the present invention, the signal coils of the plurality of magnetic sensor units may be connected in parallel to each other with respect to the detection circuit. In this case, the S/N ratio is improved. Specifically, when the intensity of the detection signal of one signal coil is Vs and the intensity of the noise signal is Vn, since it is a parallel connection, the intensity of the detection signal does not change and becomes Vs even when N pieces of the signal coils are connected. On the other hand, the intensity of the noise signal is the same as in Equation (1) described above, and the resistance value R in Equation (1) is 1/N times when N pieces of signal coils are connected in parallel. Therefore, when N pieces of signal coils are connected in parallel, the intensity Vn of the noise signal becomes $1/\sqrt{N}$ times. From the above, the S/N ratio when N pieces of signal coils units are connected in parallel can be expressed by Equation (3).

$$\frac{Vs}{Vn/\sqrt{N}} = \sqrt{N}\,\frac{Vs}{Vn} \quad \cdots (3)$$

In this manner, even in the case where N pieces of signal coils units are connected in parallel, the S/N ratio improves $\sqrt{N}$ times.

Furthermore, in the above-described first to third embodiments, an example is shown in which the excitation coils 12 of the plurality of magnetic sensor units 10 (210, 310) are connected in series, and an AC current from a common driving circuit 20 flows through them, but the present invention is not limited thereto.

In the present invention, AC currents from separate driving circuits may be applied to the respective excitation coils of the plurality of magnetic sensor unit. Further, in the case where an AC current from a common driving circuit is input, the excitation coils may be connected in parallel with each other.

Further, in the above-described first to third embodiments, an example is shown in which the excitation coil 12 and the signal coil 13 are configured by conductor patterns formed on one side (Z 1-direction side) and the other side (Z2-direction side) in the direction intersecting the board 40 with respect to the ring core 11 (magnetic core layer) of an annular shape, the present invention is not limited thereto.

In the present invention, it may be configured such that the excitation coil and the signal coil are wound around a plate-shaped (bar-shaped) magnetic core layer. In such a case, it may be configured such that the excitation coil and the signal coil are wound along the main surface of the board.

Further, in the above-described first embodiment, an example is shown in which four magnetic sensor units 10 (the magnetic sensor unit 10a, the magnetic sensor unit 10b, the magnetic sensor unit 10c, and the magnetic sensor unit 10d) are arranged in a grid of 2 x 2, but the present invention is not limited thereto.

In the present invention, three or less, or five or more of a plurality of magnetic sensor units may be arranged side by side. In such a case, the number of pieces arranged in the vertical direction and the horizontal direction need not be the same. For example, a total of six magnetic sensor units may be arranged side by side in a 2 x 3 grid.

Further, in the above-described first embodiment, an example is shown in which the excitation coil 12 and the signal coil 13 of each of the plurality of magnetic sensor units 10 are formed as conductor patterns on the common board 40, but the present invention is not limited thereto. In the present invention, a plurality of magnetic sensors arranged on mutually separate boards may be arranged side by side.

Further, in the above-described second embodiment, an example is shown in which the ring core 11 (magnetic core layer), the excitation coil 12, and the signal coil 13 are arranged on the independent board 40 in each of the plurality of magnetic sensor units 210 are arranged in a stacked manner, but the present invention is not limited thereto. In the present invention, even in the case where a plurality of magnetic sensor units is arranged in a stacked manner, a magnetic core layer, an excitation coil, and a signal coil may be formed on a common board.

Further, in the above-described second embodiment, an example is shown in which the plurality of magnetic sensor units 210 are arranged to be stacked while shifting the arrangement in a stair-like fashion to connect the terminals, but the present invention is not limited thereto. In the present invention, a plurality of magnetic sensor units may be arranged to be stacked without displacing each other.

For example, in the case of connecting the signal coils of a plurality of magnetic sensor units in parallel, the plurality of magnetic sensor units may be arranged to be stacked without displacing each other by using a through-hole or other structure for the terminal portions in each of the plurality of magnetic sensor units.

Further, in the above-described first embodiment, an example is shown in which a plurality of magnetic sensor units 10 is arranged along the main surface 40a of the board 40, and in the above-described second embodiment, an example is shown in which a plurality of magnetic sensor units 210 is arranged in a stacked configuration. In the present invention, a plurality of magnetic sensor units may be arranged by combining the arrangement of the magnetic sensor units along the main surface of the board and the stacking of the magnetic sensor units.

Further, in the above-described first to third embodiments, an example is shown in which the excitation coils 12 of each of the plurality of magnetic sensor units 10 (210, 310) have a common winding number with each other and the signal coils 13 also have a common winding number with each other, but the present invention is not limited thereto. In the present invention, it may be configured such that at least one of the excitation coils and one of the signal coils of each of the plurality of magnetic sensor units differ from each other.

For example, in the case where the winding numbers of the signal coils are different, the sensitivity of the magnetic detection detection differs in each of the plurality of magnetic sensor units. Therefore, by selectively combining magnetic sensor units with sensitivity different from each other, the detection sensitivity as a magnetic detection device can be finely tuned.

Furthermore, in the above-described first to third embodiments, an example is shown in which each of the plurality of magnetic sensor units 10 (210, 310) is a single axis sensor with one detection direction, but the present invention is not limited thereto. In the present invention, each of the plurality of magnetic sensor units may be a two-axis sensor with two mutually orthogonal detection directions.

For example, it may be configured such that the signal coil is divided into four portions along the circumferential direction of the ring core, and each of the plurality of magnetic sensor units has two detection directions perpendicular to each other by combining the pair of portions facing each other. In such a case, since two systems of detection signals are output, the signal coils that output one of the two systems of detection signals and the signal coil that outputs the other are connected to each other in each of the plurality of magnetic sensor units.

Furthermore, in the above-described first to third embodiments above, an example is shown in which the driving circuit 20 and the detection circuit 30 are configured in a common hybrid IC, but the present invention is not limited thereto. In the present invention, the driving circuitry and detection circuitry may be configured in separate hardware from each other. Further, the driving circuit and the detection circuit may be configured by a control circuit or other device other than a hybrid IC.

Furthermore, in the above-described first to third embodiments, an example was shown in which the excitation coil 12 and the signal coil 13 are electrically connected to the conductor pattern of the board 40 (250) by soldering conductors (lead wires) to the respective terminals T1 to T4 of the plurality of magnetic sensor units 210, but this invention is not limited thereto.

In the present invention, by connecting each of the plurality of magnetic sensor units to a connector or other connection provided on the board, the excitation coils and signal coils may be connected to each other by electrically connecting the excitation coils and the signal coils to the conductor pattern of the board. This allows the number of the plurality of magnetic sensor units to be easily changed, so the sensitivity of detecting magnetism can be easily adjusted. Further, the excitation coils and the signal coils of the plurality of magnetic sensor units may be connected to each other without using the board.

Further, in the above-described fourth embodiment, an example is shown in which two magnetic convergence sections 460, which are trapezoidal thin films, are arranged on each side of the ring core 11 (magnetic core layer) in the detection direction in each of the plurality of magnetic sensor units 410, but the present invention is not limited thereto. In the present invention, the magnetic convergence section may be arranged on one side of the detection direction for each of the plurality of magnetic sensor units. Further, a common magnetic convergence section may be arranged for a plurality of magnetic sensor units.

For example, in the case where a plurality of magnetic core layers is arranged side by side along the detection direction with a common axis of sensitivity, one magnetic convergence section may be commonly arranged on each of one side and the other side of the detection direction for the plurality of magnetic core layers arranged side by side.

Further, the shape of the magnetic convergence section need not be trapezoidal. In other words, the shape of the magnetic convergence section is not limited to a trapezoidal shape as long as the length of the side that is distant from the magnetic core layer is longer than the length of the side that is proximate to the magnetic core layer. For example, the magnetic convergence section may be formed as a pentagonal thin film, as in the magnetic convergence section 560 according to the modification shown in FIG. 9.

**[Aspects]**

It would be understood by those skilled in the art that the exemplary embodiments described above are specific examples of the following aspects.

**(Item 1)**

A magnetic detection device comprising:

a plurality of magnetic sensor units each including an excitation coil and a signal coil formed as conductor patterns on a board and a magnetic core layer arranged on the board;
a driving circuit configured to output an AC current to the excitation coil; and
a detection circuit configured to acquire a detection signal from the signal coil,
wherein the signal coils of the plurality of magnetic sensor units are connected to each other.

**(Item 2)**

The magnetic detection device as recited in the above-described Item 1,
wherein the excitation coils of the plurality of magnetic sensor units are connected to each other and are configured to flow an AC current output from the driving circuit, the driving circuit being common to the excitation coils.

**(Item 3)**

The magnetic detection device as recited in the above-described Item 1 or 2,

wherein the magnetic core layer has an annular shape and is arranged as a layer formed on the board along a main surface of the board, and
wherein the excitation coil and the signal coil are each arranged on the board so as to wind around the magnetic core layer by connecting the conductor pattern formed on one side in a direction intersecting the main surface of the board and the conductor pattern formed on the other side so as to sandwich the magnetic core layer.

**(Item 4)**

The magnetic detection device as recited in the above-described Item 3,

wherein the excitation coil and the signal coil are arranged so as to alternately wind around the magnetic core layer along a circumferential direction of the magnetic core layer of an annular shape,
wherein the signal coil is arranged while changing a winding direction every half circumference of the magnetic core layer, and
wherein the plurality of magnetic sensor units is arranged with their detection directions aligned with a mutually common direction, the detection direction being a direction along a line passing positions where a winding direction of the signal coil is changed in the magnetic core layer.

**(Item 5)**

The magnetic detection device as recited in any one of the above-described Items 1 to 4,
wherein the plurality of magnetic sensor units is arranged side by side along a main surface of the board.

**(Item 6)**

The magnetic detection device as recited in the above-described Item 5,
wherein the excitation coil and the signal coil of each of the plurality of magnetic sensor units are formed as conductor patterns on the board, the board being common to the excitation coil and the signal coil.

**(Item 7)**

The magnetic detection device as recited in any one of the above-described Items 1 to 6,
wherein the plurality of magnetic sensor units is arranged so that the boards each including the excitation coil, the signal coil, and the magnetic core layer are stacked along a direction intersecting the main surface of the board.

**(Item 8)**

The magnetic detection device as recited in any one of the above-described Items 1 to 7,

wherein the plurality of magnetic sensor units includes a first magnetic sensor unit and a second magnetic sensor unit, and
wherein the first magnetic sensor unit and the second magnetic sensor unit are connected such that the excitation coils are connected in series in a forward direction equal in polarity and the signal coils are connected in series in a reverse direction different in polarity.

**(Item 9)**

The magnetic detection device as recited in any one of the above-described Items 1 to 8,

wherein the excitation coils of the plurality of magnetic sensor units have a common winding number, and
wherein the signal coils of the plurality of magnetic sensor units have a common winding number.

**(Item 10)**

The magnetic detection device as recited in any one of the above-described Items 1 to 9, further comprising:
a magnetic convergence section arranged on a detection direction side of the magnetic core layer in each of the plurality of magnetic sensor units, the magnetic convergence section being configured to converge a magnetic flux with respect to the magnetic core layer.

**Claims**

1. A magnetic detection device (100) comprising:

   a plurality of magnetic sensor units (10) each including an excitation coil (12) and a signal coil (13) formed as conductor patterns on a board (40) and a magnetic core layer (11) arranged on the board (40);
   a driving circuit (20) configured to output an AC current to the excitation coil (12); and
   a detection circuit (30) configured to acquire a detection signal from the signal coil (13),
   wherein the signal coils (13) of the plurality of magnetic sensor units (10) are connected to each other.

2. The magnetic detection device (100) as recited in claim 1,
   wherein the excitation coils (12) of the plurality of magnetic sensor units (10) are connected to each other and are configured to flow an AC current output from the driving circuit (20), the driving circuit being common to the excitation coils.

3. The magnetic detection device (100) as recited in claim 1,

   wherein the magnetic core layer (11) has an annular shape and is arranged as a layer formed on the board (40) along a main surface (40a) of the board (40), and
   wherein the excitation coil (12) and the signal coil (13) are each arranged on the board (40) so as to wind around the magnetic core layer (11) by connecting the conductor pattern formed on one side in a direction intersecting the main surface (40a) of the board (40) and the conductor pattern formed on the other side so as to sandwich the magnetic core layer (11).

4. The magnetic detection device (100) as recited in claim 3,

wherein the excitation coil (12) and the signal coil (13) are arranged so as to alternately wind around the magnetic core layer (11) along a circumferential direction of the magnetic core layer (11) of an annular shape,
wherein the signal coil (13) is arranged while changing a winding direction every half circumference of the magnetic core layer (11), and
wherein the plurality of magnetic sensor units (10) is arranged with their detection directions aligned with a mutually common direction, the detection direction being a direction along a line passing positions where a winding direction of the signal coil (13) is changed in the magnetic core layer (11).

5. The magnetic detection device (100) as recited in claim 1,
wherein the plurality of magnetic sensor units (10) is arranged side by side along a main surface (40a) of the board (40).

6. The magnetic detection device (100) as recited in claim 5,
wherein the excitation coil (12) and the signal coil (13) of each of the plurality of magnetic sensor units (10) are formed as conductor patterns on the board (40), the board being common to the excitation coil and the signal coil.

7. The magnetic detection device (200) as recited in claim 1,
wherein the plurality of magnetic sensor units (210) is arranged so that the boards (40) each including the excitation coil (12), the signal coil (13), and the magnetic core layer (11) are stacked along a direction intersecting the main surface (40a) of the board (40).

8. The magnetic detection device (300) as recited in claim 1,

wherein the plurality of magnetic sensor units (310) includes a first magnetic sensor unit (310a) and a second magnetic sensor unit (310b), and
wherein the first magnetic sensor unit (310a) and the second magnetic sensor unit (310b) are connected such that the excitation coils (12) are connected in series in a forward direction equal in polarity and the signal coils (13) are connected in series in a reverse direction different in polarity.

9. The magnetic detection device (100) as recited in claim 1,

wherein the excitation coils (12) of the plurality of magnetic sensor units (10) have a common winding number, and
wherein the signal coils (13) of the plurality of magnetic sensor units (10) have a common winding number.

10. The magnetic detection device (400) as recited in claim 1, further comprising:
a magnetic convergence section (460) arranged on a detection direction side of the magnetic core layer (11) in each of the plurality of magnetic sensor units (410), the magnetic convergence section being configured to converge a magnetic flux with respect to the magnetic core layer (11).

## FIG.1

100

Magnetic detection device

30 — Detection circuit

20 — Driving circuit

10

40

10b    10a

T4 T3 T2 T1    T4 T3 T2 T1

41

10

10d    10c

T4 T3 T2 T1    T4 T3 T2 T1

X1 ↑
X2 ↓ X    Y2 ⇄ Y1    Z {⊙ Z1
       Y              ⊗ Z2}

**FIG.2**

**FIG.3**

FIG.4

FIG.5

FIG.6

## FIG.7

*FIG.8*

*FIG.9*

Europäisches
Patentamt

European
Patent Office

Office européen
des brevets

# EUROPEAN SEARCH REPORT

**Application Number**

EP 24 15 4307

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/334192 A1 (KENDALL GARY [GB]) 20 October 2022 (2022-10-20) | 1,2,5,6,9 | INV. G01R33/05 |
| Y | * paragraphs [0100], [0101]; figures 15, 16 * | 3,4,7,8,10 | |
| X | JP 2004 028708 A (OMRON TATEISI ELECTRONICS CO) 29 January 2004 (2004-01-29) | 1,2,5,6,9 | |
| Y | * paragraphs [0059] - [0087]; figures 5-14 * | 3,4,7,8,10 | |
| X | US 2004/135576 A1 (AIZAWA MANABU [JP] ET AL) 15 July 2004 (2004-07-15) | 1-3,5,6,9 | |
| Y | * paragraphs [0060], [0080] - [0082]; figures 2, 12, 13 * | 4,7,8,10 | |
| Y | JP H07 191118 A (SHIMADZU CORP) 28 July 1995 (1995-07-28) * figures 1-4 * | 3,4 | |
| Y | US 2021/111335 A1 (LAVILLE ARNAUD [CH] ET AL) 15 April 2021 (2021-04-15) * figure 2 * | 7 | TECHNICAL FIELDS SEARCHED (IPC) G01R |
| Y | US 5 642 045 A (KEEFE GEORGE ANDREW [US] ET AL) 24 June 1997 (1997-06-24) * figure 1 * | 8 | |
| Y | CN 115 248 403 A (SHANGHAI ARUISI INTELLIGENT TECH CO LTD) 28 October 2022 (2022-10-28) * figure 1 * | 10 | |
| Y | US 2015/212167 A1 (ROSS GARY [GB] ET AL) 30 July 2015 (2015-07-30) * paragraphs [0013] - [0020], [0075] - [0080]; figures 3-5 * | 1 | |

-/--

The present search report has been drawn up for all claims

| Place of search | Date of completion of the search | Examiner |
|---|---|---|
| Munich | 28 June 2024 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KR 101 090 967 B1 (DAOU XILICON TECHNOLOGY CO LTD [KR]) 8 December 2011 (2011-12-08) * figures 10, 12 * ----- | 1 | |

TECHNICAL FIELDS
SEARCHED      (IPC)

The present search report has been drawn up for all claims

| Place of search | Date of completion of the search | Examiner |
|---|---|---|
| Munich | 28 June 2024 | Philipp, Peter |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

& : member of the same patent family, corresponding
　　document

EPO FORM 1503 03.82 (P04C01)

## ANNEX TO THE EUROPEAN SEARCH REPORT
## ON EUROPEAN PATENT APPLICATION NO.

EP 24 15 4307

28-06-2024

| Patent document cited in search report | Publication date | Patent family member(s) | Publication date |
|---|---|---|---|
| US 2022334192 A1 | 20-10-2022 | EP 4025925 A1 | 13-07-2022 |
| | | GB 2588512 A | 28-04-2021 |
| | | US 2022334192 A1 | 20-10-2022 |
| | | WO 2021044169 A1 | 11-03-2021 |
| JP 2004028708 A | 29-01-2004 | NONE | |
| US 2004135576 A1 | 15-07-2004 | JP 2004138558 A | 13-05-2004 |
| | | US 2004135576 A1 | 15-07-2004 |
| JP H07191118 A | 28-07-1995 | JP 2730467 B2 | 25-03-1998 |
| | | JP H07191118 A | 28-07-1995 |
| US 2021111335 A1 | 15-04-2021 | CN 112652602 A | 13-04-2021 |
| | | EP 3805707 A1 | 14-04-2021 |
| | | JP 2021064780 A | 22-04-2021 |
| | | US 2021111335 A1 | 15-04-2021 |
| | | US 2023240153 A1 | 27-07-2023 |
| | | US 2023371401 A1 | 16-11-2023 |
| US 5642045 A | 24-06-1997 | NONE | |
| CN 115248403 A | 28-10-2022 | NONE | |
| US 2015212167 A1 | 30-07-2015 | US 2012163696 A1 | 28-06-2012 |
| | | US 2015212167 A1 | 30-07-2015 |
| KR 101090967 B1 | 08-12-2011 | NONE | |

EPO FORM P0459

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010127889 A

**Non-patent literature cited in the description**

- **SHIMADZU HYORON.** Microfabricated Thin-Film Flux-Gate Magnetic Sensor and Its Applications. *Shimadzu Hyoron Editorial Unit,* August 1999, vol. 56 (1 & 2), 19-28